# EUROPEAN PATENT APPLICATION

(11) **EP 3 401 762 A1**
(43) Date of publication of application: **14.11.2018**
(21) Application number: 18171705.9
(22) Date of filing: 10.05.2018
(51) Int. Cl.: G06F 3/01, B29C 73/16, B06B 1/06, H01L 41/193

(54) **SELF-HEALING ACTUATION SYSTEMS FOR HAPTIC SYSTEMS**

(30) Priority: 11.05.2017 US 201715592313
(71) Applicant: Immersion Corporation, San Jose, CA 95134 (US)
(72) Inventor: KHOSHKAVA, Vahid, Montreal, Québec H2W 2R2 (CA); ALGHOONEH, Mansoor, Montreal, Québec H2W 2R2 (CA)
(74) Representative: McDougall, Robert Campbell

(57) **Abstract**

Examples of devices, systems, and methods for self-healing actuation systems for haptic systems in portable electronic devices are disclosed. In one example, a flexible display (105) in a smartphone (100), tablet, or phablet has soft, thin electroactive polymer actuators (110, 115, 120, 125, 130, 135, 140, 145) bonded to the flexible display (105). These actuators (110, 115, 120, 125, 130, 135, 140, 145) contain or are coated with a self-healing material (205, 215, 225, 235, 305a, 305b, 315a, 315b, 325a, 335a, 345a, 355a). Depending on the self-healing material (205, 215, 225, 235, 305a, 305b, 315a, 315b, 325a, 335a, 345a, 355a) used, the soft, thin electroactive polymer actuators (110, 115, 120, 125, 130, 135, 140, 145) can autonomously or non-autonomously self-heal when physical damage or electrical breakdown occurs.

## Description

### FIELD

The present application generally relates to haptic devices and more generally relates to self-healing actuation systems to provide haptics in portable electronic devices.

### BACKGROUND

In order to provide more elegant electronic devices, there is a need to move away from conventional, thick product designs. To deliver haptics in these thinner electronic devices, there is a need to utilize thin, flexible actuation systems. Such activation systems, however, are vulnerable to physical damage (such as punctures, cuts, scratches, etc.) which can cause them to stop working properly and often require replacement. Moreover, these activation systems often degrade or electrically break down over time causing the activation systems to fail, again requiring replacement.

### SUMMARY

Various examples are described for devices, systems, and methods for self-healing actuation for haptic systems in portable electronic devices.

One example disclosed self-healing actuator comprises: a first layer comprising a first electrode; a second layer comprising a second electrode; a third layer arranged between and coupled to the first layer and the second layer, the third layer comprising an actuating material; and a self-healing material bonded to at least one of the first layer, the second layer or the third layer.

The self-healing actuator may be modified in any suitable way as disclosed herein, including, but not limited to, any one or more of the following.

In some examples, the actuating material comprises an electroactive polymer. The self-healing material may have a first self-healing material bonded to the third layer to heal physical damage in the electroactive polymer. The self-healing material may have a second self-healing material bonded to the first electrode to heal physical damage in the first electrode. In examples, the self-healing material is bonded to the first electrode to heal physical damage in the first electrode.

In examples, the self-healing material comprises a first self-healing material bonded to the first electrode and the second electrode to heal physical damage in the first electrode and in the second electrode, and a second self-healing material bonded to the electroactive polymer to heal physical damage in the electroactive polymer.

In examples, the first layer further comprises a third electrode and the second layer further comprises a fourth electrode. In examples, the first electrode comprises a first conductive interdigitated electrode pattern and the third electrode comprises a third conductive interdigitated electrode pattern. In examples, the second electrode comprises a second conductive interdigitated electrode pattern and the fourth electrode comprises a fourth conductive interdigitated electrode pattern. In examples, the third layer comprises a plurality of aligned piezoelectric macro-fibers with an epoxy therebetween. In some examples, the epoxy itself can comprise the self-healing material and, in other examples, the epoxy may be separate from the self-healing material.

In some examples, the self-healing material mirrors and/or is bonded to the plurality of aligned piezoelectric macro-fibers. In examples, the self-healing material mirrors and/or is bonded to the first conductive interdigitated electrode pattern of the first electrode. In examples, the self-healing material mirrors and/or is bonded to the third conductive interdigitated electrode pattern.

In examples, a first self-healing layer has a self-healing material embedded in an epoxy. The self-healing material may mirror the first conductive interdigitated electrode pattern and the third conductive interdigitated electrode pattern. The self-healing material may be bonded to the first conductive interdigitated electrode pattern and the third conductive interdigitated electrode pattern. The first self-healing layer may be bonded to the first layer with the first self-healing material aligned with the first conductive interdigitated electrode pattern and the second conductive interdigitated electrode pattern. A second self-healing layer having a second self-healing material may be embedded in an epoxy. The second self-healing material can mirror the plurality of aligned piezoelectric macro-fibers. The second self-healing material may be bonded to the plurality of aligned piezoelectric macro-fibers. The second self-healing layer may be bonded to the third layer with the second self-healing material aligned with the plurality of aligned piezoelectric macro-fibers. In examples, the self-healing actuator further comprises a third self-healing layer comprising a third self-healing material embedded in an epoxy. The third self-healing material may mirror the second conductive interdigitated electrode pattern and the fourth conductive interdigitated electrode pattern. The third self-healing material may be bonded to the second conductive interdigitated electrode pattern and the fourth conductive interdigitated electrode pattern. The third self-healing layer can be bonded to the second layer with the third self-healing material aligned with the second conductive interdigitated electrode pattern and the fourth conductive interdigitated electrode pattern.

In some examples, the self-healing material covers at least part of the first electrode and at least part of the second electrode. The self-healing material may surround the first layer, the second layer, and the third layer.

The self-healing material may be bonded to the third layer.

In examples, the self-healing material can be encapsulated within in one or more capsules. In some examples, components of the self-healing material can be encapsulated in capsules that are released when the capsules are punctured. These components may contact one another when the capsules are punctured and, when the components are in contact with one another, can self-heal damage (such as a cut, puncture, etc.) when a stimulus, such as heat, is applied. In some examples, a self-healing actuator comprises a plurality of capsules. The self-healing material may comprise a first monomer and a second monomer that reacts with the first monomer when in contact with the first monomer and a heat stimulus is applied. At least one of the capsules may have a first monomer and at least one of the capsules may have a second monomer different than the first monomer. The second monomer may react with the first monomer when in contact with the first monomer and a heat stimulus is applied. A first capsule can encapsulate the first monomer and a second capsule can encapsulate the second monomer such that the first monomer and the second monomer do not contact each other until the first capsule and the second capsule are punctured. The first capsule and the second capsule may be positioned such that the first monomer contacts the second monomer when the first capsule and the second capsule are punctured. In such examples, when the first capsule and the second capsule are punctured, the first monomer and the second monomer contact each other. Once the first monomer and the second monomer are in contact with each other, then a stimulus (such as a heat stimulus) can be applied to self-heal damage to the actuator. In some examples, if a stimulus (such as a heat stimulus) is applied before the first capsule and the second capsule have been punctured, then self-healing does not occur because the first monomer and the second monomer are not in contact with each other at that time.

The self-healing material may be a Diels-Alder polymer. The self-healing material may be configured to autonomously heal in response to being punctured. The self-healing material may be configured to heal physical damage responsive to being heated. For example, the self-healing material may heal physical damage to a layer, an electrode, an electroactive polymer, macro-fibers, or a combination thereof responsive to a stimulus, such as being heated. The self-healing material may heal physical damage responsive to being exposed to light. For example, the self-healing material may heal physical damage to a layer, an electrode, an electroactive polymer, macro-fibers, or a combination thereof responsive to being exposed to light.

These illustrative examples are mentioned not to limit or define the scope of this disclosure, but rather to provide examples to aid understanding thereof. Illustrative examples are discussed in the Detailed Description, which provides further description. Advantages offered by various examples may be further understood by examining this specification.

### BRIEF DESCRIPTION OF THE DRAWINGS

The accompanying drawings, which are incorporated into and constitute a part of this specification, illustrate one or more certain examples and, together with the description of the example, serve to explain the principles and implementations of the certain examples.
Figures 1A and 1B show an example smartphone having a flexible touchscreen display and self-healing actuators according to an example.
Figures 2A, 2B, 2C, 2D, 2E, 2F, and 2G show example self-healing electroactive polymer (EAP) actuators according to various examples.
Figures 3A, 3B, and 3C show example self-healing macro-fiber composite (MFC) actuators according to various examples.
Figure 4 shows an example method of manufacturing a self-healing actuator according to an example.
Figure 5A shows an example of a self-healing material encapsulated in capsules before any capsule is punctured.
Figure 5B shows an example of a self-healing material when some capsules are punctured.
Figure 6 shows an example artificial, stretchable skin or fabric having a self-healing material covering actuators.

### DETAILED DESCRIPTION

Examples are described herein in the context of devices, systems, and methods for self-healing actuation. Those of ordinary skill in the art will realize that the following description is illustrative only and is not intended to be in any way limiting. Reference will now be made in detail to implementations of examples as illustrated in the accompanying drawings. The same reference indicators will be used throughout the drawings and the following description to refer to the same or like items.

In the interest of clarity, not all of the routine features of the examples described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another.

### Illustrative Example of Self-Healing Actuation Device

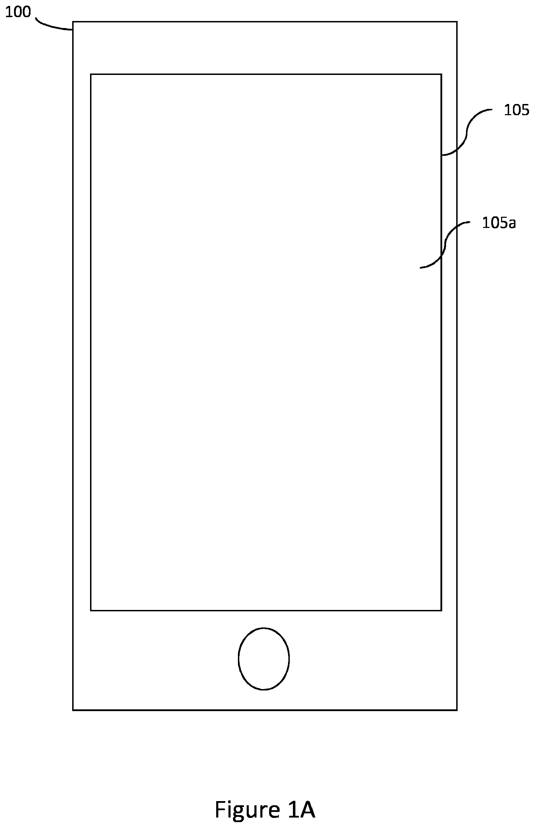

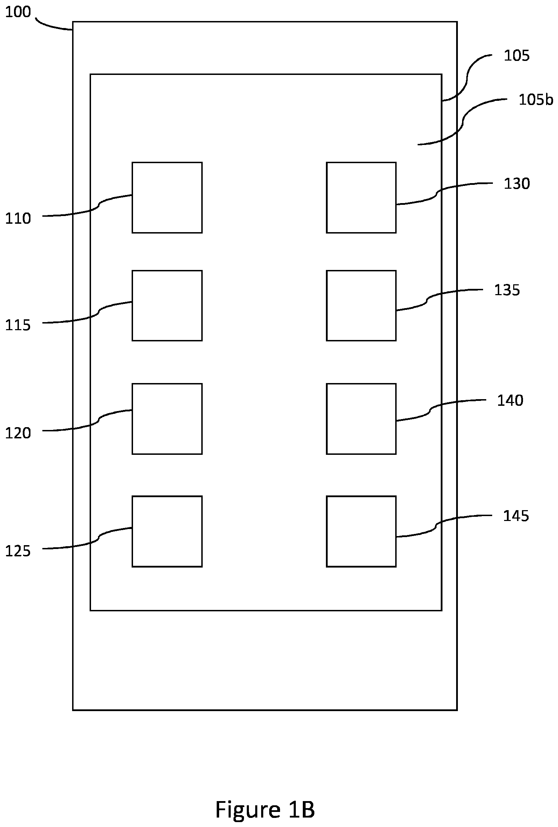

Referring now to Figures 1A and 1B, in one example a smartphone 100 has a thin, flexible touchscreen display 105. The display 105 has a front 105a that can be seen by the user when the smartphone 100 is assembled and the user is using the smartphone 100. The display 105 also has a back 105b that faces away from the user of the smartphone 100 when the smartphone 100 is assembled and the user is using the smartphone 100.

Self-healing actuators (110, 115, 120, 125, 130, 135, 140, 145) are bonded to the back 105b of the thin, flexible touchscreen display 105. The self-healing actuators (110, 115, 120, 125, 130, 135, 140, 145) can be self-healing electroactive polymer (EAP) actuators, self-healing macro-fiber composite (MFC) actuators, or a combination thereof. The smartphone 100 provides haptic effects to the user of the smartphone 100 via one or more of the self-healing actuators (110, 115, 120, 125, 130, 135, 140, 145).

Over time, as the user of the smartphone 100 uses the smartphone 100 and the display 105 flexes in various directions, one or more of the self-healing actuators (110, 115, 120, 125, 130, 135, 140, 145) can be physically damaged (e.g., cut, scratched, punctured, etc.), degrade, and/or electrically breakdown. When this occurs, traditional actuators do not function properly or completely fail; however, the self-healing actuators (110, 115, 120, 125, 130, 135, 140, 145) in the smartphone 100 can heal themselves so that they continue to function properly. In some examples, if display 105 is damaged (e.g., cut, scratched, punctured, etc.), one or more self-healing materials in display 105 and/or one or more self-healing materials bonded to display 105 can heal damage to the display 105.

For example, one or more of the self-healing actuators (110, 115, 120, 125, 130, 135, 140, 145) can be at least partially covered with a self-healing material to help repair an electrode in the self-healing actuator that has been damaged. In some examples, if the self-healing material is physically damaged, the self-healing material rebonds to itself to provide protection to the electrode in the self-healing actuator. In some examples, if the electrode is physically damaged, the self-healing material in the self-healing actuator can fill in the physically damaged portions to the electrode and can bond with the electrode to heal the damage.

In some examples, one or more of the self-healing actuators (110, 115, 120, 125, 130, 135, 140, 145) require an external stimulus to activate the self-healing process. Such self-healing actuators are referred to herein as non-autonomous self-healing actuators. For example, one or more of the self-healing actuators (110, 115, 120, 125, 130, 135, 140, 145) may self-heal when the smartphone 100 is exposed to sufficient heat. Such temperatures exceed typical ambient temperatures (e.g., greater than approximately 50 degrees Celsius) and should be high enough to cause a material transition. For example, for a plastic there is a glass transition temperature (T_{g}) where an amorphous phase changes from a glassy phase to a rubbery phase and, in this example, the material temperature would need to be at or above T_{g}. In examples, the smartphone 100 may be placed in an oven and/or put in a protective bag and placed in a dryer to activate the self-healing process thereby allowing one or more of the actuators (110, 115, 120, 125, 130, 135, 140, 145) to non-autonomously heal itself.

In other examples, one or more of the self-healing actuators (110, 115, 120, 125, 130, 135, 140, 145) do not require an external stimulus to activate the self-healing process. Such self-healing actuators are referred to herein as autonomous self-healing actuators. For example, capsules in one or more of the self-healing actuators (110, 115, 120, 125, 130, 135, 140, 145) may contain one or more self-healing materials. In this example, when capsules containing the self-healing material(s) are punctured, the self-healing material(s) are released. In this example, the self-healing material(s) can bond together to protect an electrode in the self-healing actuator. In some examples, the self-healing material(s) can bond to an electrode to fill in and repair physical damage to the electrode in the self-healing actuator.

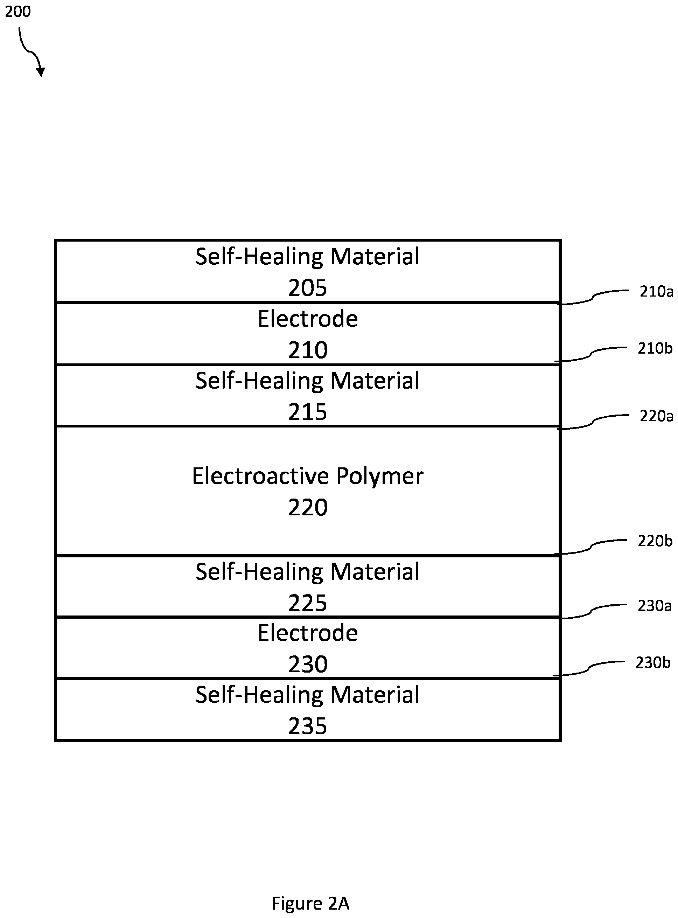

Referring now to Figures 2A thru 2G, these figures show example self-healing electroactive polymer (EAP) actuators according to various examples. In Figure 2A, EAP actuator 200 has a self-healing material 205 that is bonded to the first side 210a of electrode 210. Self-healing material 215 in these examples may be either autonomous or non-autonomous self-healing materials, or different examples may include both types of self-healing material. In this example, self-healing material 215 is bonded to the bottom side 210b of electrode 210 and the first side 220a of electroactive polymer 220 and thus is between electrode 210 and electroactive polymer 220. Self-healing material 225 is bonded to the bottom side 220b of electroactive polymer 220 and the first side 230a of electrode 230 and thus is between electroactive polymer 220 and electrode 230. Self-healing material 235 is bonded to the bottom side 230b of electrode 230.

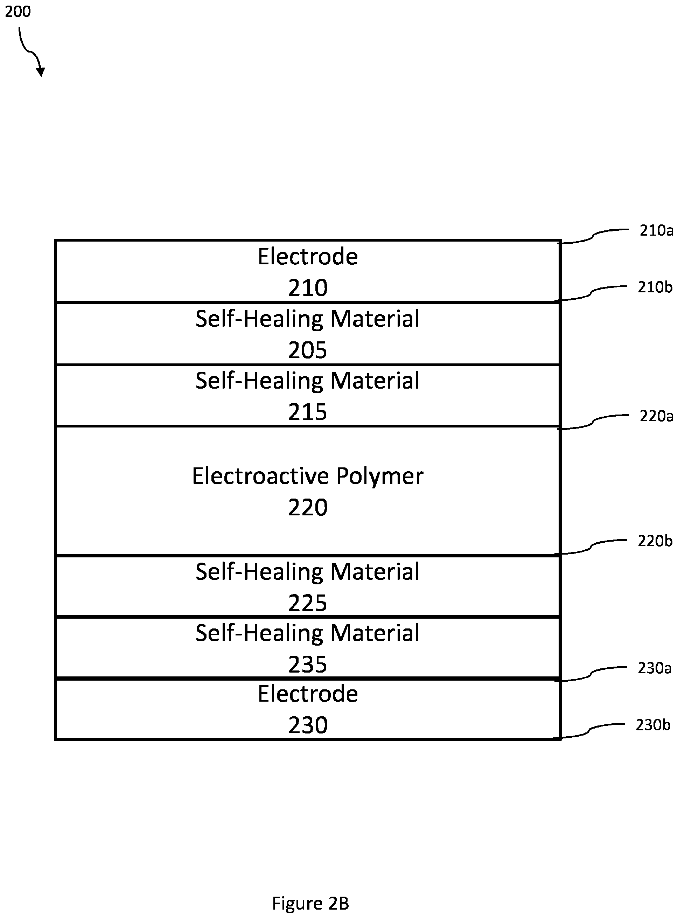

Figure 2B shows an example self-healing EAP actuator 200 according to an example. In this figure, self-healing material 205 is bonded to the bottom side 210b of electrode 210. Self-healing material 215 is bonded to self-healing material 205 and the first side 220a of electroactive polymer 220 and thus is between self-healing material 205 and electroactive polymer 220. Self-healing material 225 is bonded to the bottom side 220b of electroactive polymer 220 and self-healing material 235. Self-healing material 235 is bonded to self-healing material 225 and the first side 230a of electrode 230 and thus is between self-healing material 235 and electrode 230.

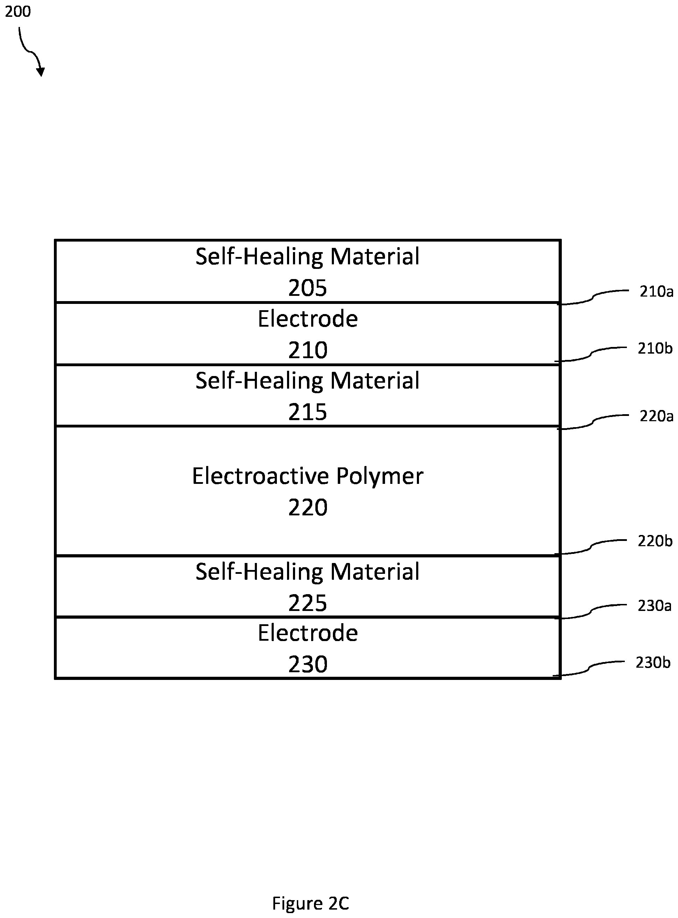

Figure 2C shows an example self-healing EAP actuator 200 according to an example. In this figure, self-healing material 205 is bonded to the first side 210a of electrode 210. Self-healing material 215 is bonded to the bottom side 210b of electrode 210 and the first side 220a of electroactive polymer 220 and thus is between electrode 210 and electroactive polymer 220. Self-healing material 225 is bonded to the bottom side 220b of electroactive polymer 220 and the first side 230a of electrode 230 and thus is between electroactive polymer 220 and electrode 230.

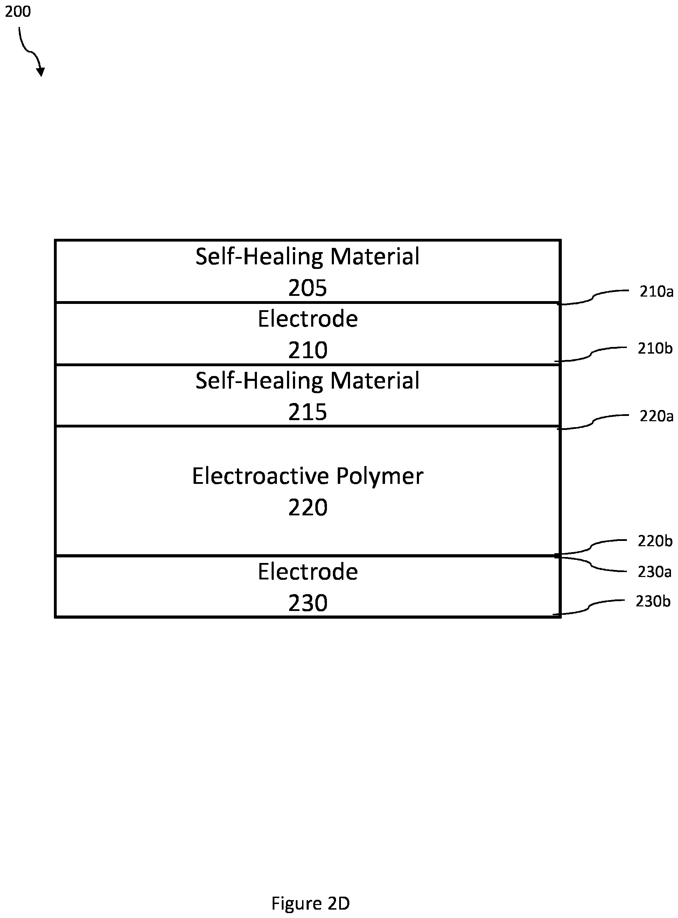

Figure 2D shows an example self-healing EAP actuator 200 according to an example. In this figure, self-healing material 205 is bonded to the first side 210a of electrode 210. Self-healing material 215 is bonded to the bottom side 210b of electrode 210 and the first side 220a of electroactive polymer 220 and thus is between electrode 210 and electroactive polymer 220. The first side 230a of electrode 230 is bonded to the bottom side 220b of electroactive polymer 220.

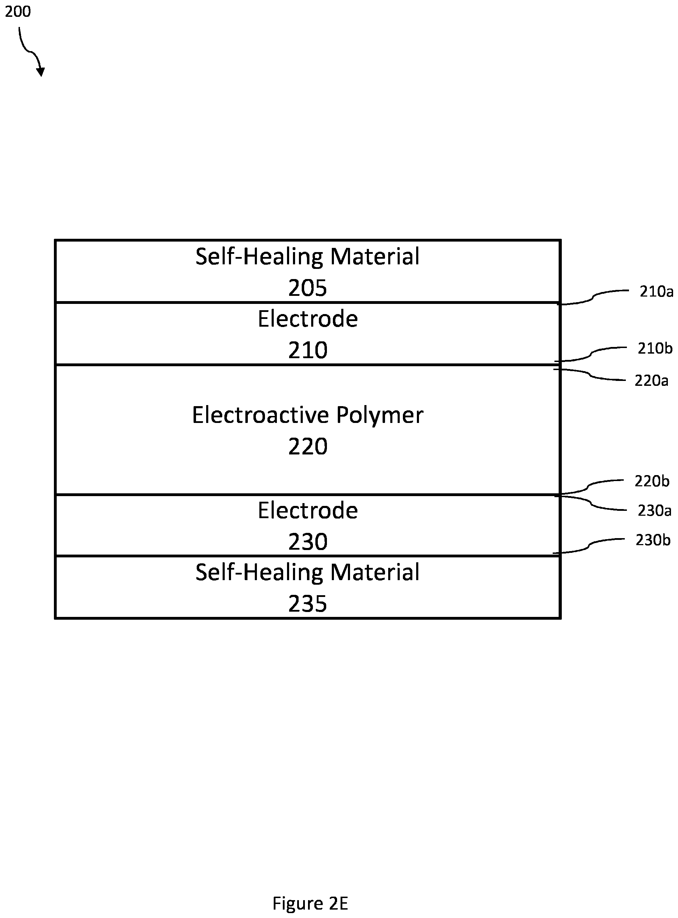

Figure 2E shows an example self-healing EAP actuator 200 according to an example. In this figure, self-healing material 205 is bonded to the first side 210a of electrode 210. The first side 220a of electroactive polymer 220 is bonded to the bottom side 210b of electrode 210. The bottom side 220b of electroactive polymer 220 is bonded to the first side 230a of electrode 230. Self-healing material 235 is bonded to the bottom side 230b of electrode 230.

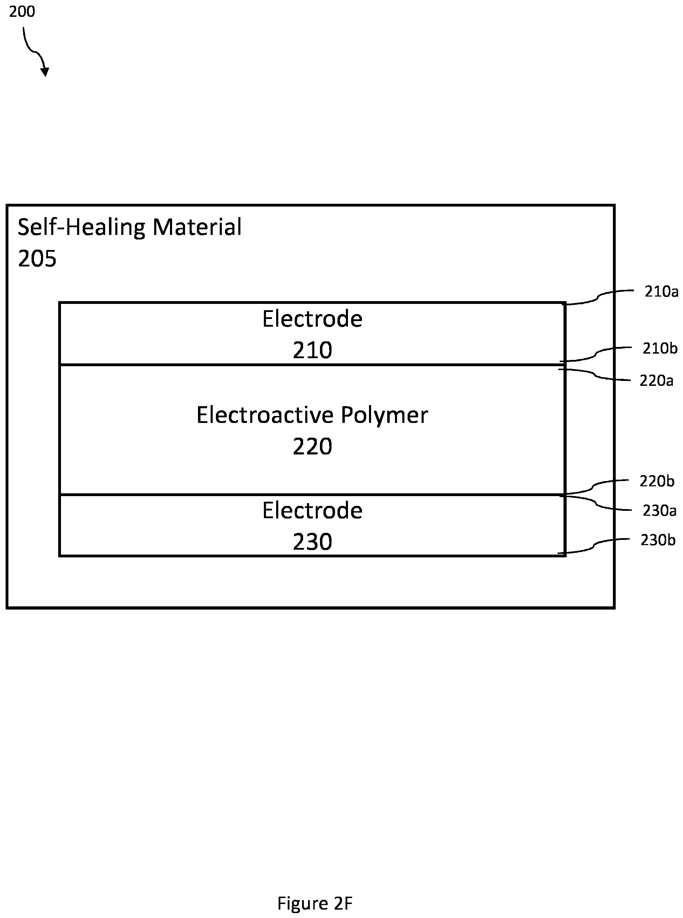

Figure 2F shows an example self-healing EAP actuator 200 according to an example. In this figure, a second side 210b of electrode 210 is bonded to a first side 220a of electroactive polymer 220 and a first side 230a of electrode 230 is bonded to a second side 220b of electroactive polymer 220. The self-healing material 205 covers electrode 210 bonded to electroactive polymer 220 bonded to electrode 230. For example, self-healing material 205 covers a first side 210a of electrode 210 and a second side 230b of electrode 230.

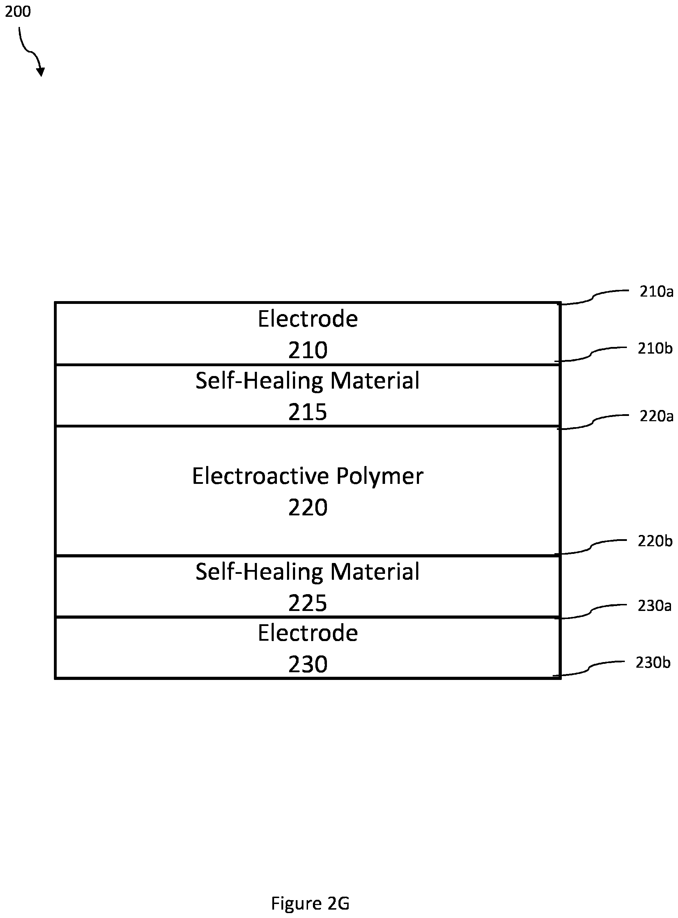

Figure 2G shows an example self-healing EAP actuator 200 according to an example. In this figure, self-healing material 215 is bonded to second side 210b of electrode 210 and is bonded to first side 220a of electroactive polymer 220. Self-healing material 225 is bonded to second side 220b of electroactive polymer 220 and is bonded to first side 230a of electrode 230.

Still referring to Figures 2A thru 2G, in various examples, self-healing materials 205, 215, 225, and/or 235 may be any suitable material that can autonomously or non-autonomously self-heal itself, an electrode, and/or an electroactive polymer. For example, self-healing materials 205, 215, 225, and/or 235 can include, but are not limited to, one or more suitable Diels-Alder (DA) polymers (i.e., polymers created from a Diels-Alder reaction), other covalent bond polymers, coordination bond polymers, hydrogen bond polymers, and/or ionomers. In some examples, self-healing materials 205, 215, 225, and/or 235 automatically re-bond when physically damaged and thus autonomously self-heal. In other examples, self-healing materials 205, 215, 225, and/or 235 require a stimulus to self-heal and thus non-autonomously self-heal. For example, self-healing materials 205, 215, 225, and/or 235 may heal when a heat stimulus or light stimulus is applied.

In some examples, self-healing materials 205, 215, 225, and/or 235 are selected and configured to heal physical damage in the self-healing material itself. In some examples, self-healing materials 205 and/or 215 are selected and configured to heal physical damage in and/or electrical breakdown of electrode 210. Self-healing materials 215 and/or 225 can be selected and configured to heal physical damage in and/or electrical breakdown of electroactive polymer 220. In some examples, self-healing materials 225 and/or 235 are selected and configured to heal physical damage in and/or electrical breakdown of electrode 230. In some examples, self-healing materials 205, 215, 225, and/or 235 are electrically conductive. Such electrically conductive materials may include one or more of carbon-nanotubes, silver, copper, gold, graphite, or another suitable electrically conductive material. In other examples, one or more of self-healing materials 205, 215, 225, and/or 235 may not be electrically conductive.

Electrodes 210 and/or 230 can be made of any suitable electrically conductive material including, but not limited to, carbon-nanotubes, silver, copper, gold, graphite, another electrically conductive material, or a combination thereof. Electroactive polymer 220 can be any suitable electroactive polymer including, but not limited to, a dielectric elastomer (DEA), a polyvinylidene fluoride (PVDF), a PVDF detivative such as co-polymer PVDF or terpolymer PVDF, polyacetylene, an ionic polymer-metal composite, another electroactive polymer, or a combination thereof. The size of a self-healing actuator can vary depending on its application. Typically, a self-healing actuator has a width of at least 2 cm, a width of at least 2 cm, and a thickness of at least 0.5 mm.

In examples, a layer is indirectly coupled to another layer. For example, in Figure 2A, electroactive polymer 220 is indirectly coupled to electrode 210 and electroactive polymer 220 is indirectly coupled to electrode 230. In some examples, a layer is directly coupled to another layer. For example, in Figure 2E electroactive polymer 220 is directly coupled to electrode 210 and is also directly coupled to electrode 230.

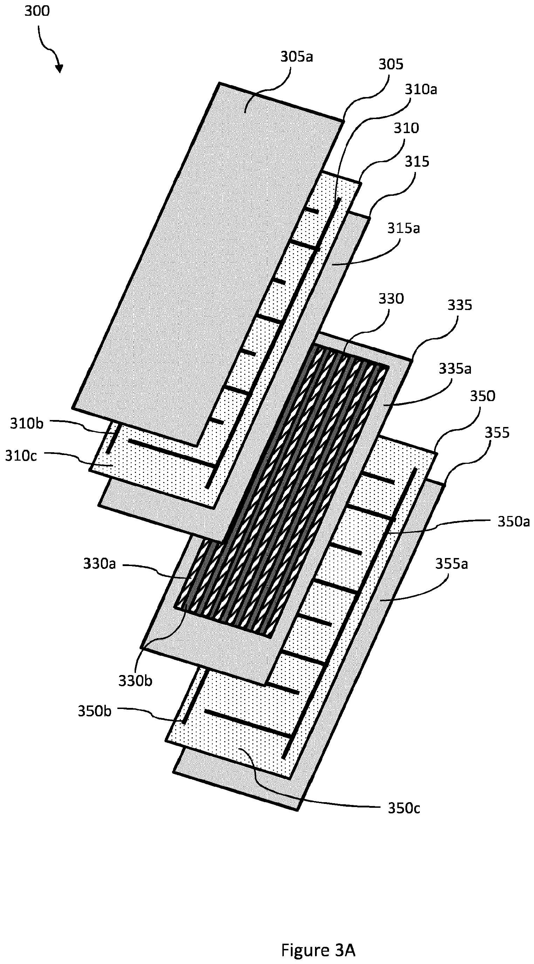

Referring now to Figures 3A thru 3C, these figures show example self-healing macro-fiber composite (MFC) actuators according to various examples. In Figure 3A, self-healing MFC actuator 300 has a self-healing layer 305 including a self-healing material 305a and is bonded to a first side of film layer 310. Film layer 310 has an electrically non-conductive material 310c with electrically conductive interdigitated electrodes 310a and 310b therebetween. In Figure 3A, self-healing layer 315 has a self-healing material 315a and is bonded to a second side of film layer 310. Self-healing layer 315 is also bonded to a first side of sheet 330. Sheet 330 has a plurality of aligned (e.g., parallel) piezoelectric macro-fibers 330a with epoxy 330b therebetween. In some examples, epoxy 330b is intermixed with a self-healing material, such as self-healing material 305a and/or self-healing material 315a. In Figure 3A, self-healing layer 335 has a self-healing material 335a and is bonded to a second side of sheet 330. Self-healing layer 335 is also bonded to a first side of film layer 350. Film layer 350 has an electrically non-conductive material 350c with electrically conductive interdigitated electrodes 350a and 350b formed thereon. In Figure 3A, self-healing layer 355 has a self-healing material 355a and is bonded to a second side of film layer 350.

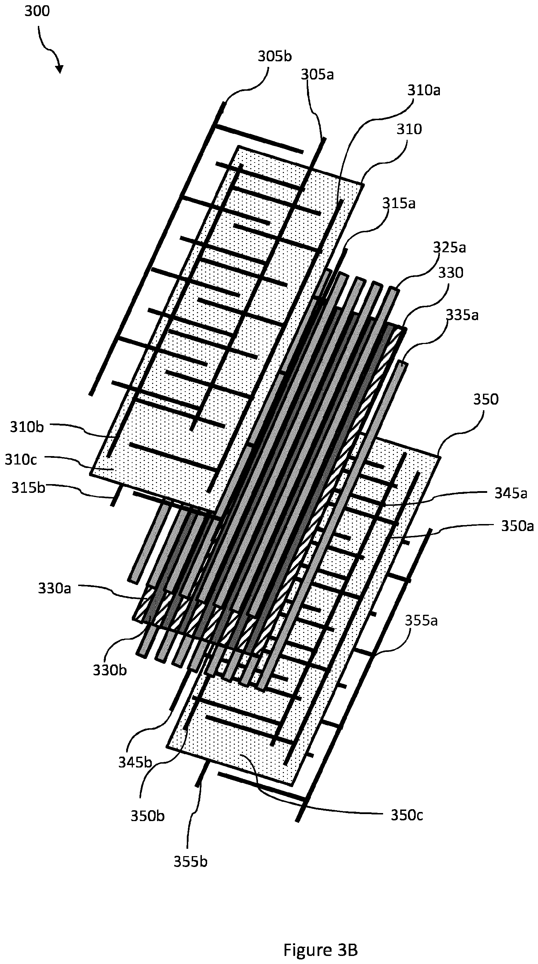

Figure 3B shows an example self-healing MFC actuator 300 according to an example. In this figure, self-healing layer 305 has self-healing material 305a and self-healing material 305b. Film layer 310 has an electrically non-conductive material 310c with electrically conductive interdigitated electrodes 310a and 310b therebetween. In Figure 3B, self-healing material 305a mirrors electrically conductive interdigitated electrode 310a, and self-healing material 305b mirrors electrically conductive interdigitated electrode 310b (e.g., the self-healing material 305b is applied in a shape corresponding to the shape of the interdigitated electrode 310b). Self-healing material 305a is bonded to the first side of film layer 310 such that self-healing material 305a aligns with and is bonded to electrically conductive interdigitated electrode 310a. Self-healing material 305b is bonded to the first side of film layer 310 such that self-healing material 305b aligns with and is bonded to electrically conductive interdigitated electrode 310b.

In Figure 3B, self-healing layer 315 has self-healing material 315a and self-healing material 315b. Self-healing material 315a mirrors electrically conductive interdigitated electrode 310a, and self-healing material 315b mirrors electrically conductive interdigitated electrode 310b. Self-healing material 315a is bonded to the second side of film layer 310 such that self-healing material 315a aligns with and is bonded to electrically conductive interdigitated electrode 315a. Self-healing material 315b is bonded to the second side of film layer 310 such that self-healing material 315b aligns with and is bonded to electrically conductive interdigitated electrode 310b.

In Figure 3B, self-healing layer 325 has self-healing material 325a. Sheet 330 has a plurality of aligned piezoelectric macro-fibers 330a with epoxy 330b therebetween. In some examples, epoxy 330b is intermixed with a self-healing material, such as self-healing material 325a or self-healing material 335a. In Figure 3B, self-healing material 325a and self-healing material 335a each mirrors the plurality of aligned piezoelectric macro-fibers 330a. Self-healing material 325a is bonded to self-healing material 315a and the first side of sheet 330 such that self-healing material 325a aligns with the plurality of aligned piezoelectric macro-fibers 330a. Self-healing material 335a is bonded to the bottom side of sheet 330 such that self-healing material 335a aligns with the plurality of aligned piezoelectric macro-fibers 330a.

Self-healing material 335a is also bonded to self-healing material 345a. Self-healing material 345a is bonded to film layer 350. Film layer 350 has an electrically non-conductive material 350c with electrically conductive interdigitated electrodes 350a and 350b therebetween. In Figure 3B, self-healing material 345a and self-healing material 355a each mirrors electronically conductive interdigitated electrode 350a, and self-healing material 345b and self-healing material 355b each mirrors electronically conductive interdigitated electrode 350b. Self-healing material 345a and self-healing material 345b are bonded to the first side of film layer 350 such that self-healing material 345a aligns with and is bonded to electrically conductive interdigitated electrode 350a and self-healing material 345b aligns with and is bonded to electrically conductive interdigitated electrode 350b.

In Figure 3B, self-healing material 355a and self-healing material 355b are bonded to the second side of film layer 350 such that self-healing material 355a aligns with and is bonded to electrically conductive interdigitated electrode 350a and self-healing material 355b aligns with and is bonded to electrically conductive interdigitated electrode 350b.

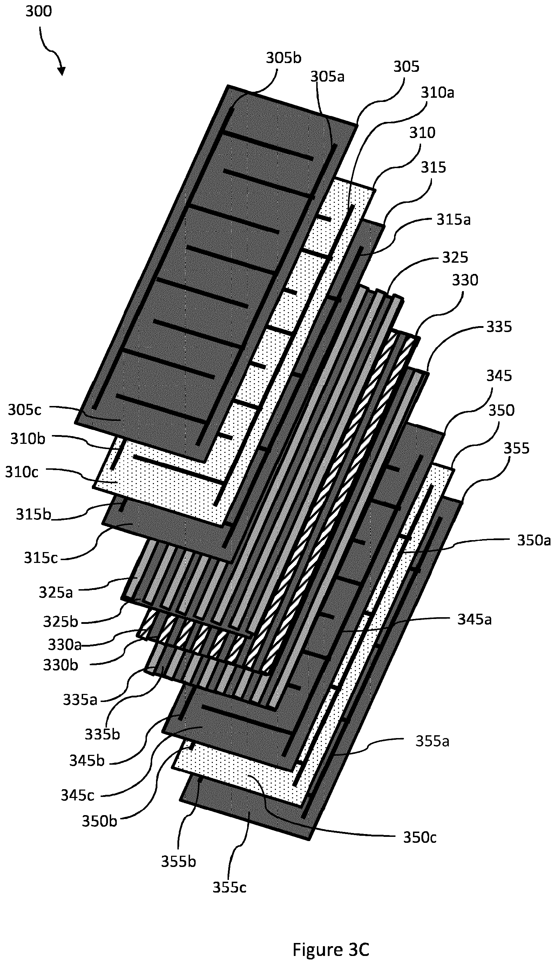

Figure 3C shows an example self-healing MFC actuator 300 according to an example. Figure 3C is similar to Figure 2B except that one or more of the self-healing materials is embedded in epoxy. For example, self-healing layer 305 in Figure 3C has a self-healing material 305a mirroring electrode 310a and a self-healing material 305b mirroring electrode 310b. In this figure, self-healing materials 305a and 305b are embedded within epoxy 305c. Likewise, self-healing layer 315 has self-healing material 315a that mirrors electrode 310a and self-healing material 315b that mirrors electrode 310b. These self-healing materials 315a and 315b are embedded within epoxy 315c.

In Figure 3C, self-healing layer 325 has self-healing material 325a embedded within epoxy 325b and self-healing layer 335 has self-healing material 335a embedded within epoxy 335b. Self-healing materials 325a and 335a mirror the plurality of aligned piezoelectric macro-fibers 330a. In Figure 3B, self-healing layer 315 is distinct from and bonded to self-healing layer 325. In other examples, self-healing layer 315 and self-healing layer 325 are a single self-healing layer. In these examples, self-healing materials 315a and 315b can be on a first side of the self-healing layer and self-healing materials 325a can be on a second side of the self-healing layer. Moreover, in these examples, an epoxy - such as epoxy 315c or 325b - surrounds self-healing materials 315a, 315b, and 325a such that self-healing material 315a mirrors electrode 310a, self-healing material 315b mirrors electrode 310b, and self-healing material 325a mirrors macro-fibers 330a. Further, in these examples, the first side of the self-healing layer is bonded to the second side of film layer 310 such that self-healing materials 315a and 315b align with electrodes 310a and b, respectively, and the bottom side of the self-healing layer is bonded to the first side of sheet 330 such that self-healing material 325a aligns with macro-fibers 330a.

Still referring to Figures 3A thru 3C, in various examples, self-healing materials 305a, 305b, 315a, 315b, 325a, 335a, 345a, 345b, 355a, and/or 355b may be any suitable material that can autonomously or non-autonomously self-heal itself, an electrode, or a macro-fiber. For example, self-healing materials 305a, 305b, 315a, 315b, 325a, 335a, 345a, 345b, 355a, and/or 355b can include, but are not limited to, one or more suitable Diels-Alder (DA) polymers (i.e., polymers created from a Diels-Alder reaction), other covalent bond polymers, coordination bond polymers, hydrogen bond polymers, and/or ionomers. In some examples, self-healing materials 305a, 305b, 315a, 315b, 325a, 335a, 345a, 345b, 355a, and/or 355b automatically re-bond when physically damaged and thus autonomously self-heal. In other examples, self-healing material 305a, 305b, 315a, 315b, 325a, 335a, 345a, 345b, 355a, and/or 355b require a stimulus to self-heal and thus non-autonomously self-heal. For example, self-healing materials 305a, 305b, 315a, 315b, 325a, 335a, 345a, 345b, 355a, and/or 355b may heal when a heat stimulus or light stimulus is applied.

In some examples, self-healing materials 305a, 305b, 315a, 315b, 325a, 335a, 345a, 345b, 355a, and/or 355b are selected and configured to heal physical damage in the self-healing material itself. In some examples, self-healing materials 305a, 305b, 315a, and/or 315b are selected and configured to heal physical damage in and/or electrical breakdown of electrodes 310a and/or 310b. In some examples, self-healing materials 345a, 345b, 355a, and/or 355b are selected and configured to heal physical damage in and/or electrical breakdown of electrodes 350a and/or 350. In some examples, self-healing materials 325a and/or 335a are selected and configured to heal physical damage in and/or electrical breakdown of macro-fibers 330a. In some examples, self-healing materials 305a, 305b, 315a, 315b, 325a, 335a, 345a, 345b, 355a, and/or 355b are electrically conductive. In other examples, one or more of self-healing materials 305a, 305b, 315a, 315b, 325a, 335a, 345a, 345b, 355a, and/or 355b may not be electrically conductive.

In examples, electrically conductive interdigitated electrodes 310a, 310b, 350a, and/or 350b are made of any suitable electrically conductive material including, but not limited to, carbon-nanotubes, silver, copper, gold, graphite, another electrically conductive material, or a combination thereof. In examples, electrically non-conductive materials 310c and/or 350c are made of any suitable electrically nonconductive material including, but not limited to, polyimide. The polyimide may be, Kapton, for example. One or more of the aligned piezoelectric macro-fibers 330a are made of any suitable fiber including, but not limited to, an unelectroded piezoelectric material such as PZT-5 piezoelectric ceramic. Any suitable bonding material can be used for bonding. For example, DP-460 epoxy, urethane, acrylic, another suitable bonding material, or a combination thereof may be used in various examples. In one impediment, epoxy 305c, 315c, 325c, 330b, 335b, 345c, and/or 355c is DP-460 epoxy.

In examples, a layer is indirectly coupled to another layer. For example, in Figure 3A, sheet 330 is indirectly coupled to film layer 310 and sheet 330 is indirectly coupled to film layer 350. In some examples, a layer is directly coupled to another layer. For example, in some examples, sheet 330 can be directly coupled to film layer 310 and/or film layer 350.

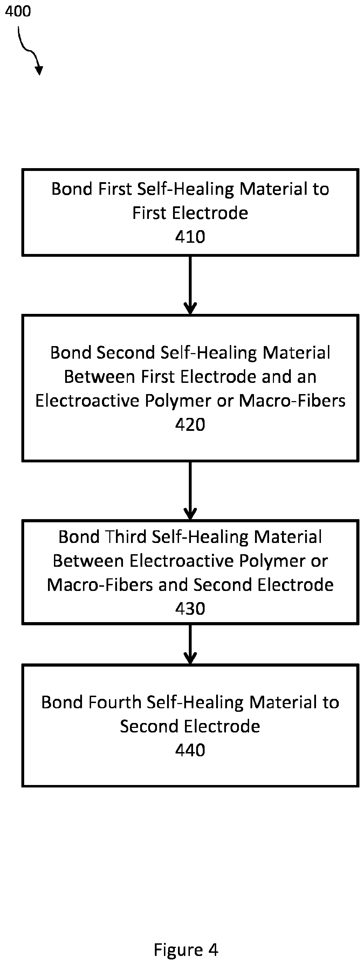

Referring now to Figure 4, this figure shows an example method 400 of manufacturing a self-healing actuator according to an example. In describing method 400, reference will be made to Figures 2 and 3. The method 400 begins in block 410 when a first self-healing material is bonded to a first electrode. For example, self-healing material 235 can be bonded to the bottom side 230b of electrode 230 as shown in Figure 2A. As another example, self-healing materials 355a and 355b can be bonded to electrodes 350a and 350b, respectively, as shown in Figure 3C.

In block 420, a second self-healing material is bonded between the first electrode and an electroactive polymer (if a self-healing EAP actuator) or macro-fibers (if a self-healing MFC actuator). For example, self-healing material 225 can be bonded between a first side 230a of electrode 230 and a bottom side 220b of electroactive polymer 220 as shown in Figure 2A. As another example, self-healing materials 345a and 345b can be bonded with electrodes 350a and 350b, respectively, as shown in Figure 3C. In this example, self-healing materials 345a and 345b are also bonded with self-healing material 335a which is bonded with macro-fibers 330a.

In block 430, a third self-healing material is bonded between the electroactive polymer (if a self-healing EAP actuator) or macro-fibers (if a self-healing MFC actuator and a second electrode. For example, self-healing material 215 can be bonded to a first side 220a of electroactive polymer and a bottom side 210 of electrode 210 as shown in Figure 2A. As another example, self-healing material 325a is bonded with macro-fibers 330a and is also bonded with self-healing materials 315a and 315b which are bonded with electrodes 310a and 310b, respectively, as shown in Figure 3C.

In block 440, a fourth self-healing material is bonded to the second electrode. For example, self-healing material 205 can be bonded to the first side 210a of electrode 210 as shown in Figure 2A. As another example, self-healing materials 305a and 305b can be bonded to electrodes 310a and 310b, respectively, as shown in Figure 3C.

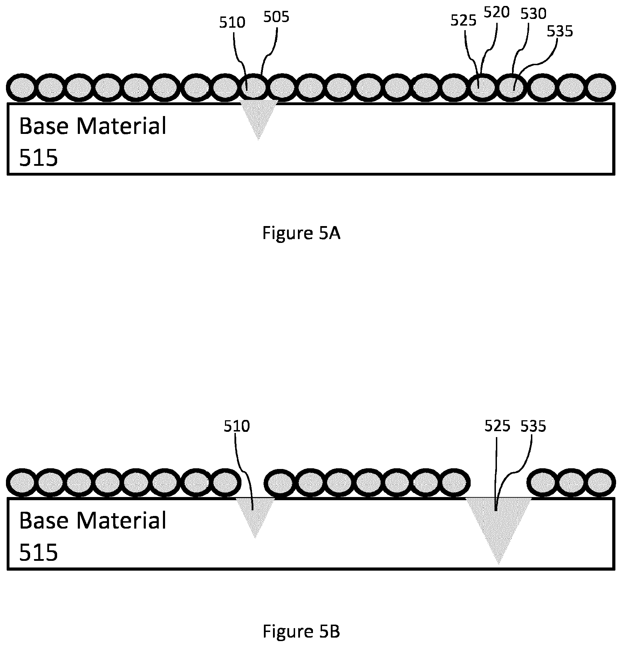

One or more of the self-healing materials discussed herein with respect to Figures 2, 3, and/or 4 can be encapsulated within a capsule. For example, referring now to Figure 5A, this figure shows an example of self-healing material 510 encapsulated in capsule 505. In this example, self-healing material 510 is released from capsule 505 when capsule 505 is punctured. Self-healing material 510 can then be used to repair damage to base material 515 as shown in Figure 5B. For example, self-healing material 510 can fill in a cut in base material 515.

In some examples, a self-healing material has multiple components that are encapsulated in different capsules. These components may contact each other when the capsules are punctured and can then be used to repair a base material. In some examples, a stimulus (such as heat) may be required for the multiple components to repair a base material after the capsules have been punctured. For example, referring to Figure 5A, a first monomer 525 of a self-healing material can be encapsulated by a first capsule 520 and a second monomer 535 of a self-healing material can be encapsulated by a second capsule 530. As shown in Figure 5A, the first monomer 525 and the second monomer 535 do not contact each other until the first capsule 520 and the second capsule 530 are punctured. Moreover, as shown in Figures 5A and 5B, the first capsule 520 and the second capsule 530 are positioned such that the first monomer 525 and the second monomer 535 contact each other when the first capsule 520 and the second capsule 530 are punctured. For example, the first capsule 520 may be adjacent to the second capsule 530. As another example, the first capsule 520 can be positioned near the second capsule 530.

In this example, as shown in Figure 5B, when the first capsule 520 and the second capsule 530 are punctured, the first monomer 525 and the second monomer 535 are released from their respective capsules and come into contact each other. The first monomer 525 and the second monomer 535 can then be used to repair damage to base material 515. In some examples, the first monomer 525 and the second monomer 535 react with each other when they contact each other to repair damage to base material 515. In other examples, a stimulus (such as a heat stimulus) may be required for the first monomer 525 and the second monomer 535 to react with each other after they contact each other to repair damage to base material 515.

The self-healing electroactive polymer (EAP) actuators and self-healing macro-fiber composite (MFC) actuators discussed herein have numerous useful applications. For example, one or more self-healing EAP actuators and/or MFC actuators can be bonded to a flexible display in a portable electronic device to provide haptics. In examples, the mechanical properties of the actuator(s) can be almost completely recovered because of the self-healing material(s) the actuators. In various examples, the portable electronic device is a smartphone, a tablet, or a phablet. In another example, a flexible, wearable strap has one or more EAP actuators and/or MFC actuators bonded to the wearable strap to provide haptics.

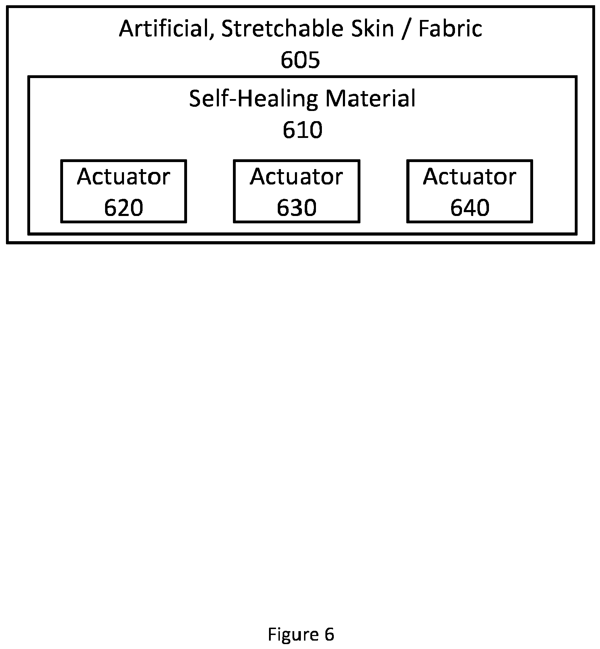

Referring now to Figure 6, this figure shows an example of an artificial, stretchable skin or film that covers actuators to provide self-healing actuation. In Figure 6, an artificial, stretchable skin or fabric 605 is coated with one or more self-healing materials 610. The artificial, stretchable skin or fabric 605 has one or more actuators - such as actuator 620, actuator 630, and actuator 640 shown in Figure 6. In this example, the self-healing material 610 helps to prevent the actuators (620, 630, 640) from failing by being physically damaged because the self-healing material 610 coats the artificial, stretchable skin or fabric 605 to separate the actuators (620, 630, 640) from the external environment. In order for the actuators (620, 630, 640) to fail because of being physically damaged, the self-healing material 610 first has to be punctured thus providing additional protection for the actuators (620, 630, 640). Moreover, depending on the self-healing material(s) 610 used to coat the artificial, stretchable skin or fabric 605, the self-healing material(s) 610 may be able to autonomously self-heal when punctured or may be able to non-autonomously self-heal such as, for example, when heat is applied.

Examples of artificial, stretchable skins or stretchable fabrics suitable for use as item 605 in Figure 6 include, but are not limited to elastic, plastic, cotton, another stretchable material, or a combination thereof. In some examples, an artificial, stretchable skin has at least one silicon elastomer and a stretchable fiber, which may be based on polyurethane. In some examples, an artificial, stretchable skin has a polymeric material containing at least one elastomer material that adds elasticity to a fiber material. As examples, a polymer blend of polyethylene (PE) with a polyurethane elastomer or nylon with a polyurethane elastomer or another elastomer mixed with a polymer matrix (such as PE or nylon) may be used in some examples. The self-healing material(s) 610 shown in Figure 6 can be one or more of the self-healing materials described herein with respect to Figures 2, 3, or 4. In various examples, the actuators 620, 630, 640 shown in Figure 6 may be electrostatic friction (ESF) actuators, electroactive polymer (EAP) actuators, macro-fiber composite (MFC) actuators, other suitable thin actuators, or a combination thereof.

The foregoing description of some examples has been presented only for the purpose of illustration and description and is not intended to be exhaustive or to limit the disclosure to the precise forms disclosed. Numerous modifications and adaptations thereof will be apparent to those skilled in the art without departing from the spirit and scope of the disclosure.

Reference herein to an example or implementation means that a particular feature, structure, operation, or other characteristic described in connection with the example may be included in at least one implementation of the disclosure. The disclosure is not restricted to the particular examples or implementations described as such. The appearance of the phrases "in one example," "in an example," "in one implementation," or "in an implementation," or variations of the same in various places in the specification does not necessarily refer to the same example or implementation. Any particular feature, structure, operation, or other characteristic described in this specification in relation to one example or implementation may be combined with other features, structures, operations, or other characteristics described in respect of any other example or implementation.

## Claims

1. A self-healing actuator (200, 300) comprising:
a first layer (310) comprising a first electrode (210, 310a);
a second layer (350) comprising a second electrode (230, 350a);
a third layer (330) arranged between and coupled to the first layer (310) and the second layer (350), the third layer (330) comprising an actuating material (220); and
a self-healing material (205, 215, 225, 235, 305a, 305b, 315a, 315b, 325a, 335a, 345a, 355a) bonded to at least one of the first layer (310), the second layer (350) or the third layer (330).

2. The self-healing actuator (200, 300) of claim 1, wherein the actuating material (220) comprises an electroactive polymer.

3. The self-healing actuator (200, 300) of claim 2, wherein the self-healing material (205, 215, 225, 235) comprises a first self-healing material bonded to the third layer to heal physical damage in the electroactive polymer (220).

4. The self-healing actuator (200, 300) of claim 2 or claim 3, wherein the self-healing material (205, 215, 225, 235) comprises a second self-healing material bonded to the first electrode (210) to heal physical damage in the first electrode (210).

5. The self-healing actuator (200, 300) of claim 2, wherein the self-healing material (205, 215, 225, 235) comprises a first self-healing material bonded to the first electrode (210) and the second electrode (230) to heal physical damage in the first electrode (210) and in the second electrode (230), and a second self-healing material bonded to the electroactive polymer (220) to heal physical damage in the electroactive polymer (220).

6. The self-healing actuator (200, 300) of claim 1,
wherein the first layer (310) further comprises a third electrode (310b) and the second layer (350) further comprises a fourth electrode (350b),
wherein the first electrode (310a) comprises a first conductive interdigitated electrode pattern and the third electrode (310b) comprises a third conductive interdigitated electrode pattern,
wherein the second electrode (350a) comprises a second conductive interdigitated electrode pattern and the fourth electrode (350b) comprises a fourth conductive interdigitated electrode pattern, and
wherein the third layer (330) comprises a plurality of aligned piezoelectric macro-fibers (330a) with an epoxy (330b) therebetween.

7. The self-healing actuator (200, 300) of claim 6, wherein the epoxy (330b) comprises the self-healing material (305a, 315a, 325a, 335a).

8. The self-healing actuator (200, 300) of claim 6 or claim 7, wherein the self-healing material (325a, 335a) mirrors and is bonded to the plurality of aligned piezoelectric macro-fibers (330a).

9. The self-healing actuator (200, 300) of any one of claims 6 to 8, wherein the self-healing material (305a, 315a) mirrors and is bonded to the first conductive interdigitated electrode (310a) pattern and, optionally, the self-healing material (305b, 315b) further mirrors and is bonded to the third conductive interdigitated electrode (310b) pattern.

10. The self-healing actuator (200, 300) of any one of claims 6 to 9, further comprising:
a first self-healing layer (305, 315) comprising the self-healing material (305a, 305b, 315a, 315b) embedded in a first epoxy (305c, 315c), wherein the self-healing material (305a, 305b, 315a, 315b) mirrors and is bonded to the first conductive interdigitated electrode (310a) pattern and the third conductive interdigitated electrode (310b) pattern; and
a second self-healing layer (325, 335) comprising a second self-healing material (325a, 335a) embedded in a second epoxy (325b, 335b), wherein the second self-healing material (325a, 335a) mirrors and is bonded to the plurality of aligned piezoelectric macro-fibers (330a).

11. The self-healing actuator (200, 300) of claim 10, further comprising:
a third self-healing layer (345, 355) comprising a third self-healing material (345a, 345b, 355a, 355b) embedded in a third epoxy (345c, 355c), wherein the third self-healing material (345a, 345b, 355a, 355b) mirrors and is bonded to the second conductive interdigitated electrode (350a) pattern and the fourth conductive interdigitated electrode (350b) pattern.

12. The self-healing actuator (200, 300) of any preceding claim, wherein the self-healing material (205, 215, 225, 235, 305a, 305b, 315a, 315b, 325a, 335a, 345a, 355a) covers at least part of the first electrode (310a, 210) and at least part of the second electrode (350a, 230).

13. The self-healing actuator (200, 300) of any preceding claim, wherein the self-healing material (510) is encapsulated within a capsule (505).

14. The self-healing actuator (200, 300) of any preceding claim, wherein the self-healing material (510) comprises a first monomer (525) and a second monomer (535) that reacts with the first monomer (525) when in contact with the first monomer (525) and a heat stimulus is applied, wherein a first capsule (520) comprises the first monomer (525) and a second capsule (530) comprises the second monomer (535) such that the first monomer (525) does not contact the second monomer (535) until the first capsule (520) and the second capsule (530) are punctured, and wherein the first capsule (520) and the second capsule (530) are positioned such that the first monomer (525) contacts the second monomer (535) when the first capsule (520) and the second capsule (530) are punctured.

15. The self-healing actuator (200, 300) of any preceding claim, wherein the self-healing material is configured to do one or more of the following:
to autonomously heal responsive to being punctured,
to heal physical damage responsive to being heated, and
to heal physical damage responsive to being exposed to light.
